(19) Europäisches Patentamt
European Patent Office
Office européen des brevets

(11) Publication number: **0 483 648 A2**

# (12) EUROPEAN PATENT APPLICATION

(21) Application number: **91118019.8**

(22) Date of filing: **23.10.91**

(51) Int. Cl.$^5$: **G03F 7/028**, C08F 2/50, C08F 4/52

(30) Priority: **25.10.90 US 603279**

(43) Date of publication of application: **06.05.92 Bulletin 92/19**

(84) Designated Contracting States: **DE FR GB IT NL**

(71) Applicant: **E.I. DU PONT DE NEMOURS AND COMPANY**
**1007 Market Street**
**Wilmington Delaware 19898(US)**

(72) Inventor: **Weed, Gregory C.**
**RD 1, Box 87**
**Towanda, Pennsylvania 18848(US)**

(74) Representative: **Werner, Hans-Karsten, Dr. et al**
**Patentanwälte von Kreisler-Selting-Werner**
**Schönwald-Fues-Dallmeyer Hilleringmann, Deichmannhaus**
**W-5000 Köln 1(DE)**

## (54) Borate coinitiators for photopolymerizable compositions.

(57) This invention relates to initiator systems for photopolymerizable compositions. More particularly, this invention pertains to photopolymerizable compositions in which the initiator system comprises a selected dye in combination with a borate anion coinitiator.

EP 0 483 648 A2

## Field of the Invention

This invention relates to initiator systems for photopolymerizable compositions. More particularly, this invention pertains to photopolymerizable compositions in which the initiator system comprises a selected dye in combination with a borate anion coinitiator.

## Background of the Invention

The use of photoinitiator systems to initiate photopolymerization is well known. When irradiated by actinic radiation, the photoinitiator system generates free radicals which initiate polymerization of the monomer or monomers. The photoinitiator system may be a single compound which absorbs actinic radiation and forms the initiating radicals or it may consist of several different materials which undergo a complex series of reactions to produce radicals. Added components, which do not absorb actinic radiation, but which increase the efficiency of the photoinitiator system, are known as coinitiators.

Many of the well-known photoinitiators or photoinitiator systems limit the applicability of photopolymerizable compositions because they are activated only by ultraviolet radiation. The availability of reliable, relatively inexpensive visible lasers which can be controlled by computer to expose the photopolymer directly, eliminating the intermediate photomask, has made it desirable to develop initiator systems which can be activated by visible radiation. Applications for photopolymerizable compositions which are sensitive to visible radiation include: graphic arts films, proofing, printing plates, photoresists, and solder masks. The preparation of holograms in photopolymerizable compositions, such as are disclosed in Haugh, U.S. Patent 3,658,526, Keys, U.S. Patent 4,942,102, Monroe, U.S. Patent 4,942,112, and Assignee's U.S. Patent Application 07/380,840, filed 7/14/89, allowed 5/4/90, also require initiator systems which can be activated by visible radiation.

A large number of free-radical generating systems have be used as visible sensitizers for photopolymerizable compositions. Photoreducible dyes with various coinitiators have been widely studied. A useful discussion of dye sensitized photopolymerization can be found in "Dye Sensitized Photopolymerization" by D. F. Eaton in Adv. in Photochemistry, Vol. 13, D. H. Volman, G. S. Hammond, and K. Gollinick, eds., Wiley-Interscience, New York, 1986, pp. 427-487. Many dye sensitized systems undergo dark reactions and are not shelf stable.

Shelf stable initiator systems containing borate anion coinitiators have been disclosed in Gottschalk, U.S. Patents 4,772,530 and 4,772,541. The photopolymerizable compositions contained a cationic dye-borate anion complex which is capable of absorbing actinic radiation and producing free radicals. Cationic methine, polymethine, triarylmethane, indoline, thiazine, xanthene, oxazine, and acridine dyes were disclosed. Triaryl alkyl borate anions were the preferred borate coinitiators.

Yamaguchi, U.S. Patent 4,902,604, discloses photopolymerizable compositions containing a salt formed by an organic cationic dye compound and a borate anion. In these salts the cationic dye compound comprised an azulene ring having a nitrogen atom or a chalcogen atom in the 2- or 4-position.

Koike, U.S. Patent 4,950,581, discloses photopolymerizable compositions containing an organic dye and a triaryl butyl borate anion coinitiator. In these systems the dye did not contain a counter anion. Merocyanine type dyes, coumarin type dyes, and xanthene and thioxanthene dyes were disclosed.

Despite the advances which have been made in visible sensitive photoinitiator systems, there is a continuing need for improved systems which have dark stability, low toxicity, efficient absorption, reasonable cost, and high photospeed.

## Summary of the Invention

This invention is a photopolymerizable composition comprising:

(A) an ethylenically unsaturated monomer capable of free-radical initiated polymerization; and

(B) an initiator system activatible by actinic radiation, said initiator system comprising:

(1) at least one dye capable of absorbing actinic radiation, said dye selected from the group consisting of:

(a)

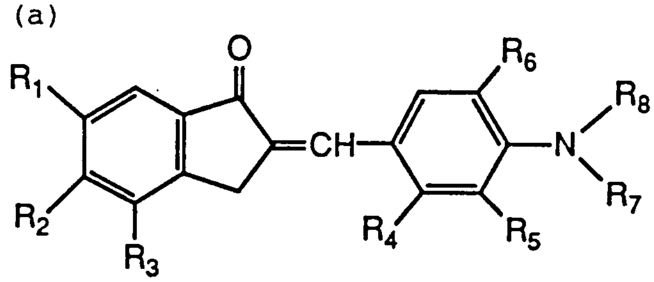

wherein:

$R_1$ and $R_2$ are each independently hydrogen, substituted or unsubstituted alkyl from 1 to 6 carbon atoms, or substituted or unsubstituted alkoxyl from 1 to 6 carbon atoms, or ($R_1$ + $R_2$) is $-OCH_2O-$, or $R_1$ and $R_2$ are joined in a carbocyclic five or six membered ring;

$R_3$ is hydrogen or methyl;

$R_4$ is hydrogen or methyl;

$R_5$ is hydrogen and $R_7$ is alkyl from 1 to 6 carbon atoms, or($R_5$ + $R_7$) is $-(CH_2)_2-$ or $-(CH_2)_3-$;

$R_6$ is hydrogen and $R_8$ is alkyl from 1 to 6 carbon atoms, or ($R_6$ + $R_8$) is $-(CH_2)_2-$ or $-(CH_2)_3-$, with the proviso that ($R_5$ + $R_7$) and ($R_6$ + $R_8$) may not be $-(CH_2)_2-$ at the same time;

(b)

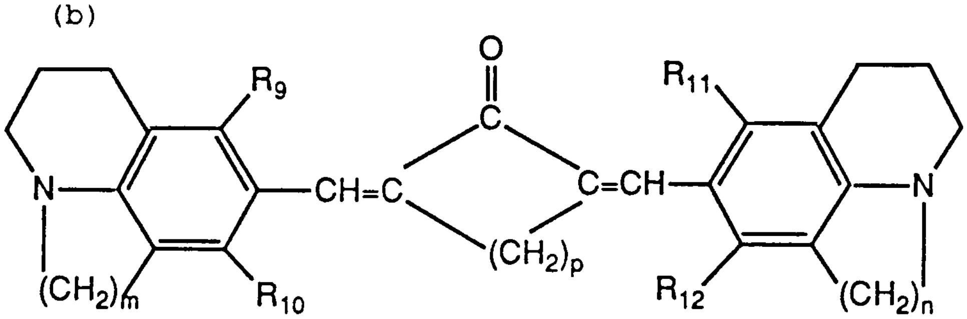

wherein:

m, n, and p are independently 2 or 3; and

$R_9$, $R_{10}$, $R_{11}$, and $R_{12}$ are each independently hydrogen, alkyl of from 1 to 4 carbon atoms, and alkoxyl from 1 to 4 carbon atoms;

(c)

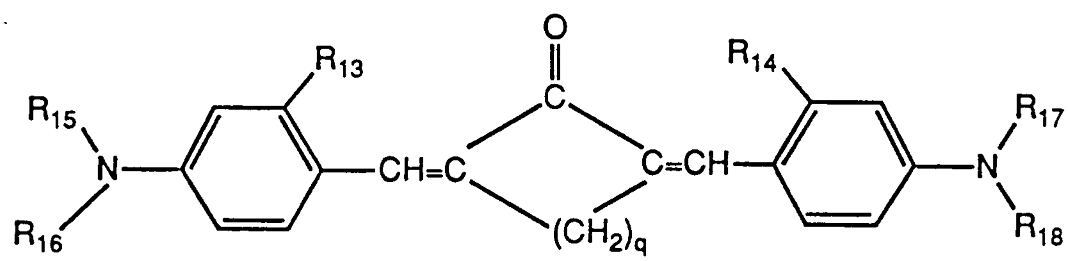

wherein:

q is 2 or 3;

$R_{13}$ and $R_{14}$ are independently hydrogen, methoxy, or alkyl from 1 to 4 carbon atoms;

$R_{15}$, $R_{16}$, $R_{17}$, and $R_{18}$ are each independently alkyl from 1 to 4 carbon atoms;

(d)

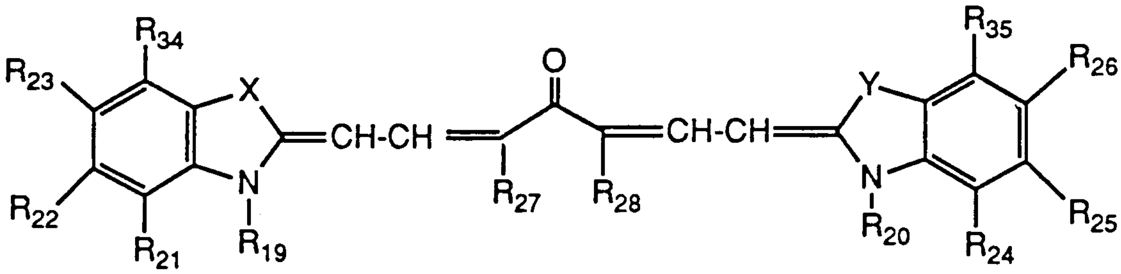

wherein:

$R_{19}$ and $R_{20}$ are each independently alkyl group of 1 to 6 carbon atoms or substituted or unsubstituted phenyl;

$R_{21}$, $R_{22}$, $R_{23}$, $R_{24}$, $R_{25}$, $R_{26}$, $R_{34}$ and $R_{35}$ are each independently hydrogen, alkyl group from 1 to 6 carbon atoms, alkoxyl group of 1 to 6 carbon atoms, or chlorine, or

$R_{21}$ and $R_{22}$ together, $R_{22}$ and $R_{23}$ together, or $R_{23}$ and $R_{34}$ together and that $R_{24}$ and $R_{25}$ together, $R_{25}$ and $R_{26}$ together, or $R_{26}$ and $R_{35}$ together are joined to form an aliphatic or aromatic ring;

($R_{27}$ + $R_{28}$) is $-(CH_2-CH_2)-$, $-(CR_{29}CR_{30})-$ or $-(CH_2CHR_{31}CH_2)-$, where $R_{29}$ and $R_{30}$ are either each hydrogen or joined to form an aromatic ring and $R_{31}$ is either hydrogen or alkyl of from 1 to 6 carbon atoms;

X and Y are independently O, S, Se or $CR_{32}R_{33}$ where $R_{32}$ and $R_{33}$ are each independently alkyl from 1 to 4 carbon atoms;

(2) a borate anion coinitiator represented by the formula:

$BX_1X_2X_3X_4$-

wherein $X_1$, $X_2$, $X_3$, and $X_4$, the same or different, are selected from the group consisting of alkyl, aryl, aralkyl, alkenyl, alkynyl, alicyclic, heterocyclic, and allyl groups, with the proviso that at least one of $X_1$, $X_2$, $X_3$, and $X_4$ is not aryl.

In a preferred embodiment the photopolymerizable composition also comprises a binder. Preferred borate anion coinitiators are triaryl alkyl borate anions. Preferred dyes are DEAW, DBC, DBI, JDI, DMJDI, dihexyloxy-JDI, JAW, and FAW in accordance with the terminology employed below.

## Detailed Description of the Invention

The novel compositions of this invention are photopolymerizable compositions in which polymerization is initiated by free radicals generated by actinic radiation. Photopolymerization proceeds by free radical initiated addition polymerization and/or crosslinking of ethylenically unsaturated monomeric compounds. These compositions comprise a photoinitiator system, at least one polymerizable monomer, and, in the preferred case, at least one binder. The photoinitiator system comprises (a) at least one dye selected from the groups herein described and (b) a borate anion coinitiator. These compositions may also comprise other ingredients, such as plasticizers, stabilizers, adhesion promoters, coating aids, and the like.

## Photoinitiator System

The photoinitiator system generates the free radicals which initiate polymerization of the monomer or monomers. The photoinitiator system should have a high molar absorption coefficient in the desired absorption range and should generate radicals with high efficiency. In addition, the system should possess such other desirable properties such as dark stability, shelf-life, absence of odor, low toxicity, and reasonable cost.

The dye of this invention may be selected from several groups of dyes. One group, which consists of derivatives of aryl ketones and p-dialkylaminoaldehydes, can be represented by the following general structure:

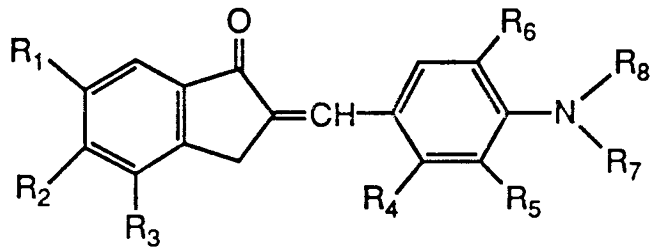

wherein:

$R_1$ and $R_2$ are each independently hydrogen, substituted or unsubstituted alkyl from 1 to 6 carbon atoms, or substituted or unsubstituted alkoxyl from 1 to 6 carbon atoms, or ($R_1$ + $R_2$) is $-OCH_2O-$ or $R_1$ and $R_2$ are joined in a carbocyclic substituted or unsubstituted five or six membered ring;

$R_3$ is hydrogen or methyl;

$R_4$ is hydrogen or methyl;

$R_5$ is hydrogen and $R_7$ is alkyl from 1 to 6 carbon atoms, or ($R_5$ + $R_7$) is $-(CH_2)_2-$ or $-(CH_2)_3-$;

$R_6$ is hydrogen and $R_8$ is alkyl from 1 to 6 carbon atoms, or ($R_6$ + $R_8$) is $-(CH_2)_2-$ or $-(CH_2)_3-$, with the proviso that ($R_5$ + $R_7$) and ($R_6$ + $R_8$) may not be $-(CH_2)_2-$ at the same time.

These dyes are selected from those disclosed in Dueber, U.S. Patent 4,162,162, as well as in U.S. Patents 4,268,667 and 4,351,893, the disclosures of which are incorporated herein by reference. A representative dye is DBI, in which $R_1$, $R_2$, $R_3$, $R_5$, and $R_6$ are hydrogen; $R_4$ is methyl; and $R_7$ and $R_8$ are ethyl. DBI has an absorbance maximum at 443 nm (measured in chloroform).

A preferred set of dyes from this group are derivatives of 1-indanones and 9-julolidine carboxaldehyde. In these dyes, $R_1$ and $R_2$ are each independently hydrogen, substituted or unsubstituted alkyl from 1 to 6 carbon atoms, or substituted or unsubstituted alkoxyl from 1 to 6 carbon atoms, or ($R_1$ + $R_2$) is $-OCH_2O-$, or $R_1$ and $R_2$ are joined in a carbocyclic five or six membered ring; $R_3$ and $R_4$ are each hydrogen; ($R_5$ + $R_7$) and ($R_6$ + $R_8$) are each $-(CH_2)_3-$.

In the more preferred set of dyes, $R_1$ and $R_2$ are each independently hydrogen, substituted or unsubstituted alkyl from 1 to 6 carbon atoms, or substituted or unsubstituted alkoxyl from 1 to 6 carbon atoms, $R_3$ and $R_4$ are hydrogen; and ($R_5$ + $R_7$) and ($R_6$ + $R_8$) are $-(CH_2)_3-$. A representative dye of this set is di-hexyloxy-JDI in which $R_1$ and $R_2$ are each n-hexyloxy. Di-hexyloxy-JDI has an absorbance maximum at 450 nm (ethanol).

The preferred dyes of this group are JDI, in which $R_1$ and $R_2$ are each hydrogen, di-hexyloxy-JDI in which $R_1$ and $R_2$ are each n-hexyloxy, and DMJDI, in which $R_1$ and $R_2$ are each methoxy. The most preferred dye is DMJDI, i.e., 1H-inden-1-one, 2,3-dihydro-5,6-dimethoxy-2-[(2,3,6,7-tetrahydro-1H,5H-benzo-[i,j]-quinolizin-9-yl)methylene]-. The absorption maximum for DMJDI is at 442 nm (dichloromethane). The absorption maximum for JDI is at 452 nm (chloroform).

Another group of dyes consists of bis(p-dialkylamino)-alpha, beta-unsaturated ketones represented by the following general structure:

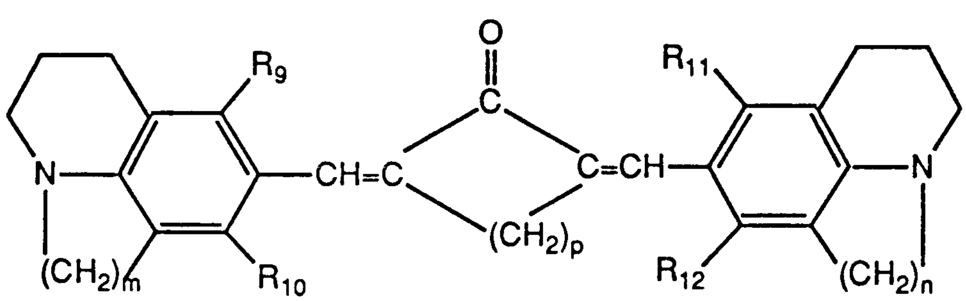

wherein:

m, n, and p are independently 2 or 3; and

$R_9$, $R_{10}$, $R_{11}$, and $R_{12}$ are each independently hydrogen, alkyl of from 1 to 4 carbon atoms, and alkoxyl of 1 to 4 carbon atoms.

These compounds are disclosed in co-assignee's U.S. Patent Application 07/228,806, filed 7/28/88. Preferred dyes of this group are those in which m and n are 3; p is 2; and $R_9$, $R_{10}$, $R_{11}$, and $R_{12}$ are each independently hydrogen, alkyl of from 1 to 4 carbon atoms, and alkoxyl for 1 to 4 carbon atoms. The most preferred member of this group is JAW, i.e., cyclopentanone, 2,5-bis[(2,3,6,7-tetrahydro-1H,5H-benzo[i,j]-quinolizin-9-yl)methylene]-, in which $R_9$, $R_{10}$, $R_{11}$, and $R_{12}$ are each hydrogen. The absorption maximum for JAW is at 496 nm (dichloromethane).

A third group of dyes consists of bis(p-dialkylamino)-alpha, beta-unsaturated ketones represented by the following general structure:

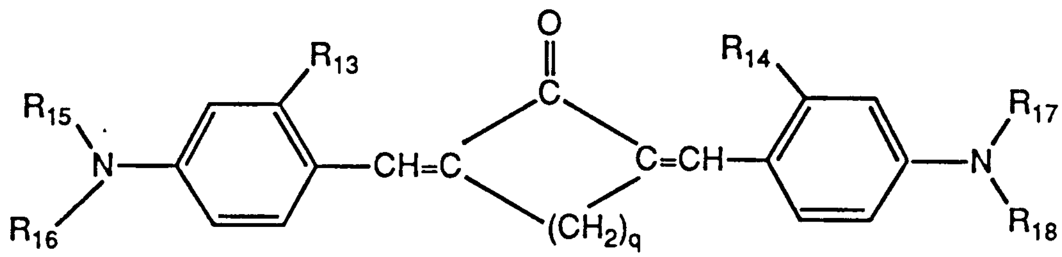

wherein:

q is 2 or 3;

$R_{13}$ and $R_{14}$ are independently hydrogen, methoxy, or alkyl from 1 to 4 carbon atoms;

$R_{15}$, $R_{16}$, $R_{17}$, and $R_{18}$ are each independently alkyl from 1 to 4 carbon atoms.

These compounds are disclosed in Baum, U.S. Patent 3,652,275, the disclosure of which is incorporated herein by reference. A preferred set of this group are symmetrical dyes in which q is 2; $R_{13}$ and $R_{14}$ are the same and either hydrogen or methyl; and $R_{15}$, $R_{16}$, $R_{17}$, and $R_{18}$ are the same and alkyl from 1 to 4 carbon atoms. The most preferred compounds are those in which $R_{15}$, $R_{16}$, $R_{17}$, and $R_{18}$ are the same and are methyl or ethyl. Members of the most preferred set are DBC, i.e., cyclopentanone, 2,5-bis-[4-(diethylamino)-2-methylphenyl]methylene]-, in which $R_{13}$ and $R_{14}$ are methyl and $R_{15}$, $R_{16}$, $R_{17}$, and $R_{18}$ are ethyl; and DEAW, i.e, cyclopentanone, 2,5-bis[4-(diethylamino)phenyl]methylene]-, in which $R_{13}$ and $R_{14}$ are hydrogen and $R_{15}$, $R_{16}$, $R_{17}$, and $R_{18}$ are ethyl. The absorption maxima for these compounds are: DBC, 481 nm; and DEAW, 477 nm (each in dichloromethane).

A fourth group of dyes is represented by the following structure:

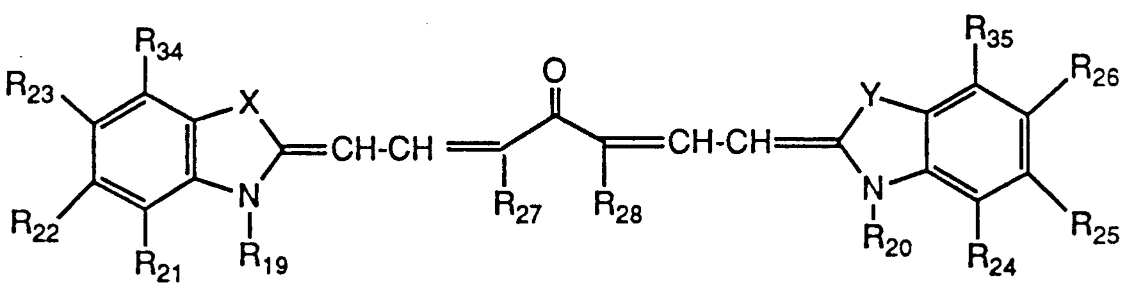

wherein:

$R_{19}$ and $R_{20}$ are each independently alkyl group of 1 to 6 carbon atoms or substituted or unsubstituted phenyl;

$R_{21}$, $R_{22}$, $R_{23}$, $R_{24}$, $R_{25}$, $R_{26}$, $R_{34}$ and $R_{35}$ are each independently hydrogen alkyl group from 1 to 6 carbon atoms, alkoxyl group of 1 to 6 carbon atoms, or chlorine, or

$R_{21}$ and $R_{22}$ together, $R_{22}$ and $R_{23}$ together, or $R_{23}$ and $R_{34}$ together and $R_{24}$ and $R_{25}$ together, $R_{25}$ and $R_{26}$ together, or $R_{26}$ and $R_{35}$ together are joined to form an aliphatic or aromatic ring;

($R_{27}$ + $R_{28}$) is $-(CH_2-CH_2)-$, $-(CR_{29}CR_{30})-$ or $-(CH_2CHR_{31}CH_2)-$, where $R_{29}$ and $R_{30}$ are either each hydrogen or joined to form an aromatic ring and $R_{31}$ is either hydrogen or alkyl of from 1 to 6 carbon atoms;

X and Y are independently O, S, Se or $CR_{32}R_{33}$ where $R_{32}$ and $R_{33}$ are each independently alkyl from 1 to 4 carbon atoms;

These compounds include those disclosed in Smothers, U.S. Patent 4,917,977, the disclosure of which is incorporated herein by reference. $R^{19}$ and $R^{20}$ may be alkyl groups up to six carbon atoms, such as, for

example, methyl, ethyl, n-propyl, i-propyl, etc. $R^{19}$ and $R^{20}$ may also be phenyl, either unsubstituted or substituted with one or more groups such as halogen, alkyl containing up to six carbon atoms, or alkoxy containing up to six carbon atoms. In a preferred set of these dyes, X and Y are identical and equal to $C(CH_3)_2$; $(R_{27}+R_{28})$ is $-(CH_2)_2-$ or $-(CH_2CHR_{31}CH_2)-$, where $R_{31}$ is H or t-butyl; $R_{19}$ and $R_{20}$ are identical and equal to CH3 or C2H5; $R_{23}$ and $R_{26}$ are hydrogen; and $R_{21}$ and $R_{22}$ are each either hydrogen or joined to form a six membered aromatic ring and $R_{24}$ and $R_{25}$ are each either hydrogen or joined to form a six membered aromatic ring. In the more preferred dyes of this group $(R_{27}+R_{28})$ is $-(CH_2)_2-$ or $-(CH_2CHR_{31}CH_2)-$, where $R_{31}$ is H or t-butyl; $R_{19}$ and $R_{20}$ are identical and equal to CH3 or C2H5; $R_{21}$, $R_{22}$, $R_{23}$, and $R_{24}$ are each hydrogen. The most preferred dye of this group is FAW in which $(R_{27}+R_{28})$ is $-(CH_2)_2-$, $R_{19}$ and $R_{20}$ are each CH3; and $R_{21}$, $R_{22}$, $R_{23}$, and $R_{24}$ are each hydrogen.

Borate anions useful as coinitiators with dyes are disclosed in Gottschalk, U.S. Patents 4,772,530 and 4,772,541 and Koike, U. S. Patent 4,950,581, the disclosures of which are incorporated by reference. The borate anions are represented by the following general formula:

$BX_1X_2X_3X_4-$

where $X_1$, $X_2$, $X_3$, and $X_4$, are independently selected from the group consisting of alkyl, aryl, aralkyl, alkenyl, alkynyl, heterocyclic, and allyl groups, with the proviso that at least one of $X_1$, $X_2$, $X_3$, and $X_4$ is not aryl.

Each group may contain up to twenty carbon atoms, but groups with seven carbon atoms or less are preferred. The alkyl groups may be linear, branched or cyclic, and may be substituted or unsubstituted. Representative alkyl groups which may be present are: methyl, ethyl, n-propyl and n-butyl. Representative cyclic alkyl groups include cyclobutyl, cyclopentyl, and cyclohexyl. Representative examples of aryl groups include phenyl and naphthyl, which may be unsubstituted or substituted with groups such as, for example, methyl and methoxy. Representative alkenyl groups are propenyl and ethynyl.

Preferably, at least one, but not more than three; of $X_1$, $X_2$, $X_3$, and $X_4$ is an alkyl group. More preferred are anions in which $X_1$-$X_4$ is a combination of three aryl groups and one alkyl group. The phenyl and p-methoxyphenyl groups are preferred aryl groups. A preferred anion is triphenylbutyl borate.

It is preferred that the cation associated with the borate anion not absorb a significant amount of actinic radiation since this would decrease photospeed. Representative cations are alkali metal cations and quaternary ammonium cations.

Quaternary ammonium cations containing four alkyl groups are preferred. The alkyl groups may be linear, branched or cyclic, and may be substituted or unsubstituted. Representative quaternary ammonium cations are tetramethyl ammonium, tetraethyl ammonium, tetrabutyl ammonium, benzyl trimethyl ammonium, benzyl dimethyl tetradecylammonium, and (2-hydroxyethyl)trimethyl ammonium.

Cations with larger alkyl groups may be used to advantage since the solubility of the borate salt in the coating solvent is generally increased. Cations in which the alkyl groups together contain up to a total thirty carbon atoms are preferred. Hydroxyl substitution may improve solubility and/or photospeed. Particularly preferred cations are (2-hydroxyethyl)trimethyl ammonium and benzyldimethyltetradecyl ammonium.

The photoinitiator systems may comprise as an optional component a 2,2',4,4',5,5'-hexaarylbisimidazole, or HABI. These compounds are described in: Chambers, U.S. Patent 3,479,185; Cescon, U.S. Patent 3,784,557; Dessauer, U.S. Patent 4,252,887 and U.S. Patent 4,311,783; Tanaka et al., U.S. Patent 4,459,349, Wada et al., U.S. Patent 4,410,621, and Sheets, U.S. Patent 4,662,286, the disclosures of which are incorporated by reference.

A preferred class of hexaarylbisimidazoles are 2-o-chlorophenyl-substituted derivatives in which the other positions on the phenyl radicals are either unsubstituted or substituted with chloro, methyl or methoxy groups. Preferred HABIs include: o-Cl-HABI, 2,2'-bis(o-chlorophenyl)-4,4,'5,5'-tetraphenyl-1,1'-biimidazole; CDM-HABI, 2-(o-chlorophenyl)-4,5-bis(m-methoxyphenyl)-imidazole dimer; TCTM-HABI, 2,5-bis(o-chlorophenyl)-4-[3,4-dimethoxyphenyl]-1H-imidazole dimer; and TCDM-HABI, the product of the oxidative coupling of 2-(o-chlorophenyl)-4,5-diphenylimidazole and 2,4-bis-(o-chlorophenyl)-5-[3,4-dimethoxyphenyl]-imidazole disclosed in Sheets, U.S. Patent 4,662,286. Although hexaarylbisimidazoles containing initiator systems normally require an added chain transfer agent or hydrogen donor for efficient initiation, an added chain transfer agent or hydrogen donor is unnecessary in the practice of this invention.

Monomer/Binder

The composition contains at least one ethylenically unsaturated compound which undergoes free-radical initiated polymerization, generally known as a monomer. The composition contains at least one such material and may contain a mixture of such materials. In general, preferred monomers for phototopolymer applications have boiling points greater than 100 ° C, more preferably, greater than 150 ° C.

Typical monomers are: unsaturated esters of alcohols, preferably polyols, such as, diethylene glycol diacrylate, glycerol triacrylate, ethylene glycol dimethacrylate, pentaerythritol tri- and tetraacrylate and methacrylate; unsaturated amides, such 1,6-hexamethylene bis-acrylamide; vinyl esters such as divinyl succinate, divinyl phthalate, and divinyl benzene-1,3-disulfonate; styrene and derivatives thereof; and N-vinyl compounds, such as N-vinyl carbazole. Numerous other unsaturated monomers polymerizable by free-radical initiated polymerization and useful in photopolymerizable compositions are known to those skilled in the art. For photoresist applications the preferred monomers are trimethylol propane triacrylate, the triacrylate ester of ethoxylated trimethylolpropane, tetraethylene glycol diacrylate, and tetraethylene glycol dimethacrylate.

The binder is an optional component present in the preferred photopolymerizable compositions of this invention. The binder is a preformed macromolecular polymeric or resinous material. In general, the binder should be soluble, or at least swellable, in the coating solvent and compatible with the other components of the photopolymerizable system. Representative binders are poly(methyl methacrylate) and copolymers of methyl methacrylate with other alkyl acrylates, alkyl methacrylates, methacrylic acid, and/or acrylic acid; poly(vinyl acetate) and its partially hydrolyzed derivatives; gelatin; cellulose esters and ethers, such as cellulose acetate butyrate; and polyethylene oxides. Numerous other binders useful in photopolymerizable compositions are known to those skilled in the art.

Although the borate anion is generally unstable in the presence of strong acid, the use of acidic binders in the practice of this invention is not precluded. It is preferred, however, that the binder contain acid units derived from weakly acidic monomers, such as acrylic acid and methacrylic acid, and/or the binder have a low acid number. For photoresist applications the preferred binders are copolymers of methyl methacrylate, ethyl acrylate, and methacrylic acid. Copolymers of methyl methacrylate, ethyl acrylate, and methacrylic acid copolymerized with a small amount of allyl methacrylate may also be used to advantage.

As disclosed in Keys, U.S. Patent 4,942,102, Monroe, U.S. Patent 4,942,112, and Assignee's U.S. Patent Application 07/380,840, filed 7/14/89, allowed 5/4/90, in the preferred compositions adapted for the preparation of holograms either the monomer or the binder contains one or more moieties selected from the group consisting of (1) an aromatic moiety selected from the group consisting of (i) substituted or unsubstituted phenyl, (ii) substituted or unsubstituted naphthyl, and (iii) substituted or unsubstituted heterocyclic aromatic moiety having up to three rings; (2) chlorine; (3) bromine and mixtures thereof; and the other constituent is substantially free of said moiety.

For systems in which the monomer contains the indicated group and the binder is free of the indicated group preferred liquid monomers are: 2-phenoxyethyl acrylate, 2-phenoxyethyl methacrylate, phenol ethoxylate monoacrylate, 2-(p-chlorophenoxy)ethyl acrylate, p-chlorophenyl acrylate, phenyl acrylate, 2-phenylethyl acrylate, 2-(1-naphthyloxy)ethyl acrylate, o-biphenyl methacrylate, o-biphenyl acrylate, and mixtures thereof. Preferred solid monomers, which may be used in combination with liquid monomers are: N-vinyl carbazole; 2,4,6-tribromophenyl acrylate or methacrylate; pentachlorophenyl acrylate or methacrylate; 2-naphthyl acrylate or methacrylate; 2-(2-naphthyloxy)ethyl acrylate or methacrylate; and mixtures thereof. Preferred binders for use in these systems are: cellulose acetate butyrate; poly(methyl methacrylate); poly(vinyl butyral); poly(vinyl acetate); and fluorine containing binders containing 3 to 25% by weight fluorine, such as copolymers of vinyl acetate with tetrafluoroethylene and/or hexafluoropropylene. For reflection holograms, the preferred binders are poly(vinyl butyral), poly(vinyl acetate), and copolymers of vinyl acetate with tetrafluoroethylene and/or hexafluoropropylene containing 3 to 25% by weight fluorine, such the 82:18 (mole%) vinyl acetate/tetrafluoroethylene copolymer.

For systems in which the binder contains the indicated group and the monomer is free of the indicated group, preferred monomers are: triethyleneglycol diacrylate and dimethacrylate, diethyleneglycol diacrylate, decanediol diacrylate, ethoxyethoxyethyl acrylate, and iso-bornyl acrylate. Preferred binders for these systems are: polystyrene and copolymers containing at least 60% styrene. Particularly preferred binders include polystyrene, 75:25 poly(styrene/acrylonitrile), and 70:30 poly(styrene/methyl methacrylate), as well as mixtures thereof.

If crosslinking of the holographic photopolymer is desired, up to five weight percent of at least one multifunctional monomer containing two or more terminal ethylenically unsaturated groups may be incorporated into the composition. The polyfunctional monomer must be compatible with the other components

of the composition and is preferably a liquid. Suitable polyfunctional monomers include di-(2-acryloxyethyl)-ether of bisphenol A, ethoxylated bisphenol A diacrylate, and the like. A preferred crosslinking is ethoxylated bisphenol A diacrylate.

Other Components

Other components conventionally added to photopolymerizable compositions can be present to modify the physical properties of the film. Such components include: plasticizers, thermal stabilizers, optical brighteners, ultraviolet radiation absorbing materials, adhesion modifiers, coating aids, and release agents.

A plasticizer may be present to modify adhesion, flexibility, hardness, and other mechanical properties of the film in a conventional fashion. When a binder is present, a plasticizer would be selected which is compatible with the binder as well as the monomer and other components of the composition. With acrylic binders, for example, plasticizers can include dibutyl phthalate and other esters of aromatic acids; esters of aliphatic polyacids, such as diisooctyl adipate; aromatic or aliphatic acid esters of glycols, polyoxyalkylene glycols, aliphatic polyols; alkyl and aryl phosphates; and chlorinated paraffins. In general, water insoluble plasticizers are preferred for greater high humidity storage stability, but are not necessary to get improved latitude.

Many ethylenically unsaturated monomers are subject to thermal polymerization, especially when stored for long periods or at elevated temperatures. Normally a conventional thermal polymerization inhibitor will be present to improve the storage stability the photopolymerizable composition. The nitroso dimers described in Pazos, U.S. Patent 4,168,982, are also useful. Since monomers generally contain thermal polymerization inhibitors added by their manufacturers, it is frequently unnecessary to add additional inhibitor.

Nonionic surfactants may be added to the photopolymerizable composition as coating aids. Typical coating aids are polyethylene oxides, such as Polyox® WSRN, and fluorinated nonionic surfactants, such as Fluorad® FC-430 and Fluorad® FC-431.

Depending on the application, other inert additives can be employed such as dyes, pigments and fillers. These additives are generally present in minor amounts so as not to interfere with the exposure of the photopolymerizable layer.

Composition

While the composition of the photopolymerizable composition will depend on the intended application, when the composition is to be used as a dry film, in general, the binder should be at least 25% and the monomer should not exceed 60%, based on the total weight of the composition. If the amount of binder is below approximately 25%, or the amount of monomer exceeds approximately 60%, the composition has insufficient viscosity to form a solid film. While the amount of initiator system present will depend on the thickness of the layer and the desired optical density for the intended application, in general, 0.1% to 10% will be present.

Typical compositions are: binder(s) 25 to 90%, preferably 45 to 75%; monomer(s), 5 to 60%, preferably, 15 to 50%; plasticizer, 0 to 25%, preferably, 0 to 15%; photoinitiator system, 0.05 to 10%, preferably 0.1 to 5%; and other ingredients, 0 to 5%, typically 0 to 4%.

The amount of dye present depends on the wavelength(s) of actinic radiation used for exposure, the absorption spectrum of the dye, and the thickness of the photopolymer coating. As described by Thommes and Webers, J. Imag. Sci., 29, 112 (1985), an optical density of 0.43 produces efficient photopolymerization for systems which are developed by washout, such as photoresists. It is generally preferred that the absorption maximum of the dye be matched to the intensity maximum of the source of actinic radiation. In general the dye will comprise 0.05 to 1.0% preferably 0.1 to 0.5% of the composition.

The amount of borate salt present is limited by its solubility. Although as much as 1% or more borate salt may be added in favorable cases, addition of too much borate salt may adversely affect the dark stability and shelf life of the photopolymer. In general, the concentration of borate salt should be between 0.05 and 1%. A preferred range is 0.1 to 1.0%.

Substrates/Coating

The photopolymerizable compositions can be coated onto a wide variety of substrates. By "substrate" is meant any natural or synthetic support, preferable one which is capable of existing in a flexible or rigid form. For example, the substrate can be a metal sheet or foil, a sheet or film of synthetic organic resin, cellulose paper, fiberboard, and the like, or a composite of two or more of these materials.

The particular substrate will generally be determined by the intended application. For example, when printed circuits are produced, the substrate may be a plate which is a copper coating on fiberboard; in the preparation of of lithographic printing plates, the substrate may be anodized aluminum. Specific substrates include alumina-blasted aluminum, anodized aluminum, alumina-blasted polyethylene terephthalate film, polyethylene terephthalate film, e.g., resin-subbed polyethylene terephthalate film, polyvinyl alcohol-coated paper, cross-linked polyester-coated paper, nylon, glass, cellulose acetate film, heavy paper such as lithographic paper, and the like.

The photopolymerizable layer may prepared by mixing the ingredients of the photopolymerizable composition in a solvent, such as dichloromethane, usually in the weight ratio of 15:85 to 25:75 (solids to solvent), coating on the substrate, and evaporating the solvent. Coatings should be uniform. While the thickness of the layer will depend on the intended application, for dry film photoresists the coating should should have a thickness of 0.2 to 4 mil (5 to 100 microns), preferably 0.5 to 2 mil (13 to 50 microns), when dry. For protection, a release film, such as polyethylene or polypropylene, may be placed over the photopolymerizable layer after the solvent evaporates.

Alternatively, since photopolymer compositions are quickly and efficiently coated onto polymer films using continuous web coating techniques, it may be convenient to coat the photopolymerizable composition onto a polymer film support, such as polyethylene terephthalate film, and laminate the resulting photopolymerizable layer to the substrate prior to exposure. The photopolymerizable layer may be protected until it is ready for use by, preferably, a release film, such as polyethylene or polypropylene, applied as the coated polymer film emerges from the drier. After removal of the release film, the photopolymerizable layer can then be laminated to the support. The polymer film support then acts as a coversheet which is removed after exposure.

Exposure/Image Formation

Any convenient source or sources of actinic radiation providing wavelengths in the region of the spectrum that overlap the absorption bands of the sensitizer can be used to activate photopolymerization. By "actinic radiation" is meant radiation which is active to produce the free-radicals necessary to initiate polymerization of the monomer(s). The radiation can be natural or artificial, monochromatic or polychromatic, incoherent or coherent, and for high efficiency should correspond closely to in wavelength to the absorption of the initiator system. Conventional light sources include fluorescent lamps, mercury, metal additive and arc lamps. Coherent light sources are xenon, argon ion, and ionized neon lasers, as well as tunable dye lasers and the frequency doubled neodymium:YAG laser, whose emissions fall within or overlap the visible absorption bands of the sensitizer.

For the exposure of holographic photopolymer systems coherent light sources, i.e., lasers, are required. Typically ion lasers, which have the required stability and coherence length but operate at a few lines of fixed wavelength, are used. With the development of photopolymer films that are sensitized across the visible spectrum, tunable lasers are required to match the broad spectral sensitivity of these materials. Since it is often desirable to record the hologram or holographic optical element, i.e., a hologram which acts as a diffraction grating, a mirror, a lens, or a combination of optical elements, with the same wavelength actinic radiation which will be used for reconstruction, tunable lasers offer added flexibility of recording a hologram and making a holographic optical element at any desired wavelength or at more than one selected wavelength.

Many wavelength tunable laser sources are now practical and can be used for holography. One type of tunable laser, the dye laser, can operate at any wavelength from the ultraviolet to the infra-red by the proper choice of pump source and dye medium. Dye laser systems can be pulsed with pulses of light as short as a few femtoseconds or can operate in the continuous wave mode. Continuous wave dye lasers with linear and ring cavity configurations can be pumped by other lasers, for example argon and krypton ion lasers, resulting in high average power. The bandwidth of the dye lasers can be narrowed with the use of intracavity etalons resulting in long coherence lengths. Advantages of these laser systems are the added control of wavelength and coherence length.

In the preparation of holograms from the compositions of this invention, the hologram is fixed by a second, overall exposure to actinic radiation. If the hologram is a reflection hologram and the binder is poly(vinyl butyral), poly(vinyl acetate), or a copolymer of vinyl acetate with tetrafluoroethylene and/or hexafluoropropylene containing 3 to 25% by weight fluorine, the refractive index modulation of the hologram can be enhanced by heating to 100-150°C for 0.5-1.5 hr following overall exposure.

The photopolymerizable compositions of this invention show good visible light sensitization and photospeed. They may be exposed with a variety of visible light sources. The broad sensitization range enables polymeric images, which may be further processed by development to produce resist images, or other relief images, to be formed. These compositions are useful in printing plates for offset and letter press, engineering drafting films, as well as photoresists in liquid or dry film form for making printed circuits or in solder masks. The resist can be either solvent soluble or aqueous developable. Solder masks are protective coatings which are selectively applied to portions of a printed circuit board to confine solder to pad areas on the board and to prevent bridging between conductors during tinning operations and during soldering of components. A solder mask also functions to prevent or minimize corrosion of the base copper conductors and as a dielectric to insulate certain components in adjacent circuitry.

The compositions of this invention are useful for the formation of holograms in which sensitivity to visible lasers is required. One or more of the dyes of this invention may be combined with each other, with other dyes which can be used in combination with borate anions, and/or with other initiator systems to produce photopolymerizable compositions with broad spectral sensitivity. Multiple holograms, generated by holographic exposure with actinic radiation of different wavelengths, can be prepared in these materials. These holograms are particularly useful in the preparation of multicolor display holograms. They can also be used as holographic notch filters when it is desired to protect against more than one wavelength of radiation.

Other specific uses for the compositions of this invention and for the holograms and multicolor holograms prepared therefrom will be evident to those skilled in the art.

The advantageous properties of this invention can be observed by reference to the following examples which illustrate, but do not limit, the invention.

## EXAMPLES

### GLOSSARY

| | |
|---|---|
| Carboset® 1034 | Poly(methyl methacrylate/ethyl acrylate/methacrylic acid) (44/35/21); MW 50,000; $T_g$ 87°C; Union Carbide, Danbury, CT |
| o-Cl-HABI | 1,1'-Biimidazole, 2,2'-bis[o-chlorophenyl]-4,4',5,5'-tetraphenyl-; CAS 1707-68-2 |
| DEAW | Cyclopentanone, 2,5-bis[4-(diethylamino)phenyl]methylene]-;CAS 38394-53-5 |
| DMJDI | 1H-Inden-1-one, 2,3-dihydro-5,6-dimethoxy-2-[(2,3,6,7-tetrahydro-1H,5H-benzo[i,j]-quinolizin-9-yl)methylene]-; CAS 80867-05-6 |
| FAW | Cyclopentanone, 2,5-bis[2-(1,3-dihydro-1,3,3-trimethyl-2H-indol-2-ylidene)-ethylidene]-; CAS 27713-85-5 |
| FC-430 | Fluorad® FC-430, fluorinated nonionic surfactant; CAS 11114-17-3; 3M Company |
| JAW | Cyclopentanone, 2,5-bis[(2,3,6,7-tetrahydro-1H,5H-benzo[i,j]quinolizin-9-yl)-methylene]- |
| Photomer® 4039 | Phenol ethoxylate monoacrylate; CAS 56641-05-5; Henkel Process Chemical Company |
| Sartomer 349 | Ethoxylated bisphenol A diacrylate; CAS 24447-78-7; Sartomer Company, West Chester, PA |
| Vinac® B-100 | Poly(vinyl acetate); M.W. 350,000; CAS 9003-20-7; Air Products; Allentown, PA |
| TMAB | Tetramethylammonium triphenylbutyl borate |
| TMPEOTA | Triacrylate ester of ethoxylated trimethylolpropane; CAS 28961-43-5 |
| TMPTA | Trimethylolpropane triacrylate; 2-ethyl-2-(hydroxymethyl)-1,3-propanediol triacrylate; CAS 15625-89-5 |

In the Examples which follow it should be understood that "coating solution" refers to the mixture of solvent and additives which is coated, even though some of the additives may be in suspension rather than in solution, and that "total solids" refers to the total amount of nonvolatile material in the coating solution even though some of the additives may be nonvolatile liquids at ambient temperature. All parts and percentages are by weight unless otherwise indicated.

Example 1

This example illustrates that borate anion and the dyes of this invention initiate polymerization. All operations were carried out under yellow lights. A stock solution containing Carboset® 1034 (65.0%), TMPEOTA (26.0%), and TMPTA (9.0%) was prepared by dissolving the ingredients in 2-butanone (54.5% total solids). The indicated initiators were added to aliquiots of the stock solution prior to coating. The indicated percentage of added initiator is the weight of added initiator in grams relative to 100 g of solids in the stock solution.

Solutions were board coated on 23 micron thick clear polyethylene terephthalate film with a 200 micron doctor blade to give a dry film thickness of approximately 38 microns. The coating solvent was 2-butanone. In some cases 5% of 1-propanol or 2-propanol was added to increase the solubility of the ingredients in the coating solution.

Films were hot roll laminated to copper, exposed under a Stouffer-41 target (Stouffer Industries, South Bend, IN) using a PC-130 printer (Du Pont, Wilmington, DE). The polyethylene terephthalate was left in place as a coversheet during exposure. The Stouffer-41 target contains forty one sixth root of two steps. The polyethylene terephthalate film was removed and the exposed samples developed at 50% breakpoint (29° C, 1% aqueous sodium carbonate) using a Chemcut aqueous processor (Chemcut, State College, PA).

All exposed films which were capable of holding steps were also capable of imaging at least an 250 micron line and space pattern. Those exposed films which were incapable of holding steps were also incapable of holding the line and space pattern. The results are shown in Table 1.

Table 1

| Initiator System | Exposure ($mJ/cm^2$) | $(2)^{1/6}$ Steps | | Relative Photospeed[b] |
|---|---|---|---|---|
| | | No Borate | Borate[a] | |
| None | 1620 | 0 | 0 | c |
| 0.28% DMJDI | 815 | 15 | 21 | 2.0 |
| 0.28% DMJDI + 2.00% o-Cl-HABI | 34 | 23 | 26 | 1.5 |
| 0.28% DEAW | 815 | 14 | 25 | 3.6 |
| 0.12% JAW | 815 | 14 | 22 | 2.5 |
| 0.12% FAW | 1607 | 0 | 6 | d |

a 0.12% Tetramethyl ammonium triphenylbutyl borate (TMAB) added.
b Photospeed of composition with borate added relative to the same composition without borate
c Control - no photopolymerization with or without added borate.
d Not calculable - greater than 2.0.

Example 2

This example illustrates DMJDI and borate anion initiate photopolymerization and that added HABI enhances photopolymerization. The procedure of Example 1 was repeated with a composition containing 0.12% tetramethyl ammonium triphenylbutyl borate and varying amounts of DMJDI. Evalutions were carried out without and without added HABI. The results are given in Table 2.

Table 2

| DMJDI[a] | o-Cl-HABI | Exposure (mJ/cm$^2$) | $(2)^{1/6}$ Steps No HABI[b] | HABI | Relative Photospeed[c] |
|---|---|---|---|---|---|
| 0.28% | 0.67% | 76 | 23 | 26 | 1.4 |
| " | " | 128 | 29 | 31 | 1.3 |
| 0.14% | 2.00% | 128 | 34 | 36 | 1.3 |
| 0.28% | 2.00% | 128 | 38 | 41d | 1.4 |

a 0.12% Tetramethyl ammonium triphenylbutyl borate (TMAB) added to all samples

b Number of steps produced without added HABI

c Photospeed of composition with the indicated amount of HABI added relative to the same composition without HABI

d Maximum number of steps of the step wedge.

## Example 3

This example illustrates the use an intitiator system containing borate anion, HABI, and FAW in a holographic photopolymer system. A coating solution was prepared by dissolving 12.02 g of Vinac® B-100; 3.56 g of Photomer® 4039; 0.540 g of Sartomer 349; 1.44 g of N-vinylcarbazole; 0.0360 g of o-Cl HABI; 0.036 g of TMAB; 0.0090 g of FAW; and 0.360 g of Fluorad® FC-430 in a mixture of 3.50 g of methanol and 68.40 g of dichloromethane. The coating solution was coated onto a support of 50 micron clear polyethylene terephthalate film at a speed of 4 cm/sec using a Talboy web coater equipped with an 200 micron doctor knife, 3.6 M drier set at 50-70 ° C, and a laminator station. A cover sheet of 23 micron polyethylene terephthalate film was laminated to the coating as it exited the drier. Dry coating thickness was 24 microns.

The coated film was cut into an 10X13 cm sections. The coversheet was removed, and the film mounted onto a clear glass plate by laminating the exposed tacky coating directly onto the plate. The 50 micron polyethylene terephthalate film support was left in place during the subsequent handling, exposure, and thermal processing steps.

The sample mounted on glass plate was evaluated by recording holographic mirrors and determining their reflection efficiency as a function of wavelength and exposure. Holographic mirrors were formed by first tightly clamping the coating sample-plate between a clear glass cover-plate and a front-surface aluminum mirror with thin xylene layers in-between, and then exposing to a collimated 514 nm argon-ion laser beam oriented perpendicular to the film plane and passing, in order, through the glass cover-plate, xylene layer, film support, coating, glass sample-plate, and xylene layer and then reflecting back onto itself off the mirror. The laser beam had a 2.0 cm diameter and an intensity of 10 mW/cm$^2$. A series of sixteen holographic mirrors were recorded with the laser exposure time incrementally varied from 0.22 seconds to 40.0 seconds, corresponding to an exposure range of 2.2-400 mJ/cm$^2$.

After the laser exposure series was completed, the glass cover-plate, aluminum mirror, and xylene layers were removed and the coating was overall exposed to ultraviolet and visible light from a Theimer-Strahler #5027 mercury-arc photopolymer lamp (Exposure Systems Corp., Bridgeport, CT) mounted in a Douthitt DCOP-X exposure unit (Douthitt Corp., Detroit, MI). The coating was then thermally processed by heating at 100 ° C for 60-65 min in a forced-air convection oven, after which the transmission spectrum of each holographic mirror was recorded using a standard double-beam scanning spectrophotometer (Perkin Elmer model Lambda-9) with the sample beam oriented perpendicular to the hologram film plane.

The maximum reflection efficiency and reflection wavelength of each mirror were measured from their transmission spectra. Graphs of reflection efficiency versus total laser exposure were used to determine photospeed, which is defined in this example as the minimum exposure required to obtain maximum holographic reflection efficiency. The maximum reflection efficiency was 37% at 516 nm. Photospeed was 200 $mJ/cm^2$.

## Claims

**1.** A photopolymerizable composition, said composition comprising:

(A) an ethylenically unsaturated monomer capable of free-radical initiated polymerization; and

(B) an initiator system activatible by actinic radiation, said initiator system comprising:

(1) at least one dye capable of absorbing actinic radiation, said dye selected from the group consisting of:

(a)

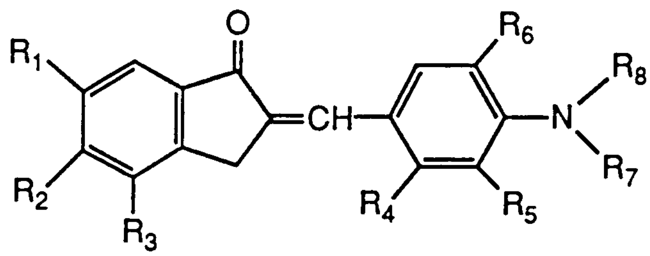

I

wherein:

$R_1$ and $R_2$ are each independently hydrogen, substituted or unsubstituted alkyl from 1 to 6 carbon atoms, or substituted or unsubstituted alkoxyl from 1 to 6 carbon atoms, or ($R_1$ + $R_2$) is $-OCH_2O-$, or that $R_1$ and $R_2$ are joined in a carbocyclic five or six membered ring;

$R_3$ is hydrogen or methyl;

$R_4$ is hydrogen or methyl;

$R_5$ is hydrogen and $R_7$ is alkyl from 1 to 6 carbon atoms, or ($R_5$ + $R_7$) is $-(CH_2)_2-$ or $-(CH_2)_3-$;

$R_6$ is hydrogen and $R_8$ is alkyl from 1 to 6 carbon atoms, or ($R_6$ + $R_8$) is $-(CH_2)_2-$ or $-(CH_2)_3-$, with the proviso that ($R_5$ + $R_7$) and ($R_6$ + $R_8$) may not be $-(CH_2)_2-$ at the same time;

(b)

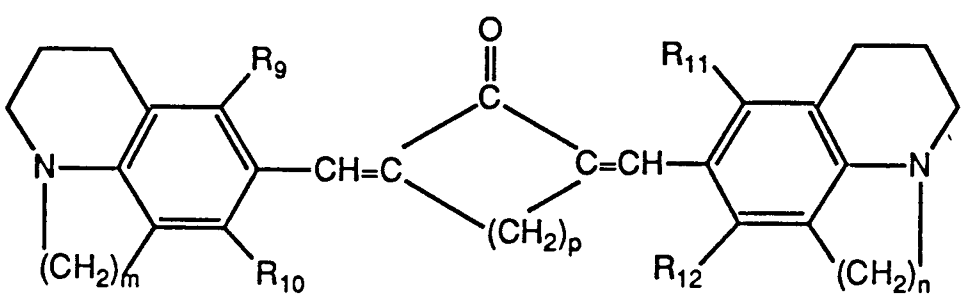

II

wherein:

m, n, and p are independently 2 or 3; and

$R_9$, $R_{10}$, $R_{11}$, and $R_{12}$ are each independently hydrogen, alkyl of from 1 to 4 carbon atoms, and alkoxyl from 1 to 4 carbon atoms;

(c)

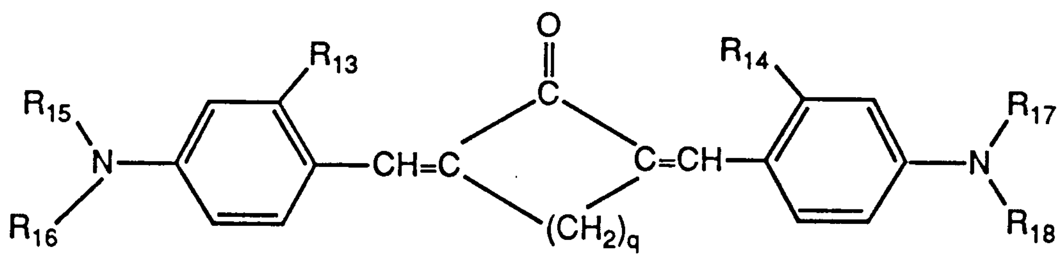

III

wherein:

q is 2 or 3;

$R_{13}$ and $R_{14}$ are independently hydrogen, methoxy, or alkyl from 1 to 4 carbon atoms;

$R_{15}$, $R_{16}$, $R_{17}$, and $R_{18}$ are each independently alkyl from 1 to 4 carbon atoms;

(d)

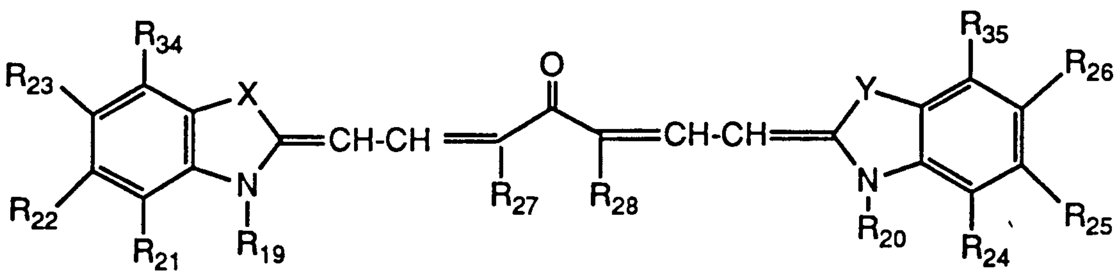

IV

wherein:

$R_{19}$ and $R_{20}$ are each independently alkyl group of 1 to 6 carbon atoms or substituted or unsubstituted phenyl;

$R_{21}$, $R_{22}$, $R_{23}$, $R_{24}$, $R_{25}$, $R_{26}$, $R_{34}$ and $R_{35}$ are each independently hydrogen, alkyl group from 1 to 6 carbon atoms, alkoxyl group of 1 to 6 carbon atoms, or chlorine, or

$R_{21}$ and $R_{22}$ together, $R_{22}$ and $R_{23}$ together, or $R_{23}$ and $R_{34}$ together and that $R_{24}$ and $R_{25}$ together, $R_{25}$ and $R_{26}$ together, or $R_{26}$ and $R_{35}$ together are joined to form an aliphatic or aromatic ring;

($R_{27}$ + $R_{28}$) is $-(CH_2-CH_2)-$, $-(CR_{29}CR_{30})-$ or $-(CH_2CHR_{31}CH_2)-$, where $R_{29}$ and $R_{30}$ are either each hydrogen or joined to form an aromatic ring and $R_{31}$ is either hydrogen or alkyl of from 1 to 6 carbon atoms;

X and Y are independently O, S, Se or $CR_{32}R_{33}$ where $R_{32}$ and $R_{33}$ are each independently alkyl from 1 to 4 carbon atoms;

(2) a borate anion coinitiator represented by the formula:

$BX_1X_2X_3X_4$-

wherein $X_1$, $X_2$, $X_3$, and $X_4$, the same or different, are selected from the group consisting of alkyl, aryl, aralkyl, alkenyl, alkynyl, alicyclic, heterocyclic, and allyl groups, with the proviso that at least one of $X_1$, $X_2$, $X_3$, and $X_4$ is not aryl.

**2.** A composition of claim 1 wherein at least one, but not more than three, of $X_1$, $X_2$, $X_3$, and $X_4$ is an alkyl group and wherein each group contains not greater than twenty carbon atoms.

**3.** A composition of claim 1 wherein said dye is selected from the group consisting of DEAW, DBC, DBI, JDI, di-hexyloxy-JDI, DMJDI, JAW, and FAW.

**4.** A composition of claim 1 wherein said initiator system additionally comprises a hexaarylbisimidazole.

**5.** A composition of claim 1 wherein said composition additionally comprises a binder.

**6.** A composition of claim 5 wherein at least one, but not more than three, of $X_1$, $X_2$, $X_3$, and $X_4$ is an alkyl group and wherein each group contains not greater than twenty carbon atoms.

**7.** A composition of claim 5 wherein said initiator system additionally comprises a hexaarylbisimidazole.

**8.** A composition of claim 5 wherein said dye has structure of component (a).

**9.** A composition of claim 8 wherein $R_1$ and $R_2$ are each independently hydrogen, substituted or unsubstituted alkyl from 1 to 6 carbon atoms, or substituted or unsubstituted alkoxyl from 1 to 6 carbon atoms, with the proviso that ($R_1$ + $R_2$) may equal $-OCH_2O-$, or that $R_1$ and $R_2$ may be joined in a carbocyclic substituted or unsubstituted five or six membered ring; $R_3$ and $R_4$ are each hydrogen; ($R_5$ + $R_7$) and ($R_6$ + $R_8$) are each $-(CH_2)_3-$.

**10.** A composition of claim 9 wherein $X_1$-$X_4$ is a combination of three aryl groups and one alkyl group and wherein each group contains not greater than twenty carbon atoms.

**11.** A composition of claim 9 wherein said initiator system additionally comprises a hexaarylbisimidazole.

**12.** A composition of claim 9 wherein $R_1$ and $R_2$ are each independently hydrogen, substituted or unsubstituted alkyl from 1 to 6 carbon atoms, or substituted or unsubstituted alkoxyl from 1 to 6 carbon atoms, $R_3$ and $R_4$ are hydrogen; and ($R_5$ + $R_7$) and ($R_6$ + $R_8$) are $-(CH_2)_3-$.

**13.** A composition of claim 12 wherein said dye is DMJDI.

**14.** A composition of claim 5 wherein said dye has structure of component (b).

**15.** A composition of claim 14 wherein m and n are 3; p is 2; and $R_9$, $R_{10}$, $R_{11}$, and $R_{12}$ are each independently hydrogen, alkyl of from 1 to 4 carbon atoms, and alkoxyl for 1 to 4 carbon atoms.

**16.** A composition of claim 15 wherein $X_1$-$X_4$ is a combination of three aryl groups and one alkyl group and wherein each group contains not greater than twenty carbon atoms.

**17.** A composition of claim 15 wherein said initiator system additionally comprises a hexaarylbisimidazole.

**18.** A composition of claim 15 wherein said dye is JAW.

**19.** A composition of claim 5 wherein said dye has structure of component (c).

**20.** A composition of claim 19 wherein q is 2; $R_{13}$ and $R_{14}$ are the same and either hydrogen or methyl; and $R_{15}$, $R_{16}$, $R_{17}$, and $R_{18}$ are the same and alkyl from 1 to 4 carbon atoms.

**21.** A composition of claim 19 wherein $X_1$-$X_4$ is a combination of three aryl groups and one alkyl group and wherein each group contains not greater than twenty carbon atoms.

**22.** A composition of claim 19 wherein said initiator system additionally comprises a hexaarylbisimidazole.

**23.** A composition of claim 20 wherein $R_{15}$, $R_{16}$, $R_{17}$, and $R_{18}$ are the same and are methyl or ethyl.

**24.** A composition of claim 23 wherein said dye is DBC or DEAW.

**25.** A composition of claim 5 wherein said dye has structure of component (d).

**26.** A composition of claim 25 wherein X and Y are identical and equal to $C(CH_3)_2$; ($R_{27}+R_{28}$) is $-(CH_2)_2-$ or $-(CH_2CHR_{31}CH_2)-$, where $R_{31}$ is H or t-butyl; $R_{19}$ and $R_{20}$ are identical and equal to $CH_3$ or $C_2H_5$; $R_{23}$ and $R_{26}$ are hydrogen; and $R_{21}$ and $R_{22}$ are each either hydrogen or joined to form an aromatic ring and $R_{24}$ and $R_{25}$ are each either hydrogen or joined to form an aromatic ring.

**27.** A composition of claim 26 wherein $X_1$-$X_4$ is a combination of three aryl groups and one alkyl group and wherein each group contains not greater than twenty carbon atoms.

**28.** A composition of claim 26 wherein said initiator system additionally comprises a hexaarylbisimidazole.

**29.** A composition of claim 26 wherein ($R_{27}+R_{28}$) is $-(CH_2)_2-$ or $-(CH_2CHR_{31}CH_2)-$, where $R_{31}$ is H or t-butyl; $R_{19}$ and $R_{20}$ are identical and equal to CH3 or C2H5; $R_{21}$, $R_{22}$, $R_{23}$, and $R_{24}$ are each hydrogen.

**30.** A composition of claim 29 wherein said dye is FAW.